# EUROPÄISCHE PATENTSCHRIFT

(11) **EP 0 584 530 B1**
(45) Veröffentlichungstag und Bekanntmachung des Hinweises auf die Patenterteilung: **13.03.1996**
(21) Anmeldenummer: 93111654.5
(22) Anmeldetag: 21.07.1993
(51) Int. Cl.: H05K 13/04, H05K 7/12

(54) **Chassis mit unlösbar mit dem Chassis verbundenen Befestigungselementen**
Chassis with permanent fixing elements
Chassis avec éléments de fixation non-démontables

(30) Priorität: 06.08.1992 DE 4226016
(43) Veröffentlichungstag der Anmeldung: 02.03.1994
(73) Patentinhaber: NOKIA TECHNOLOGY GmbH, D-75175 Pforzheim (DE)
(72) Erfinder: Apitz, Siegfried, D-75328 Schömberg 4 (DE)

(56) Entgegenhaltungen:
- EP-A- 0 019 667
- EP-A- 0 033 472
- FR-A- 2 554 306
- US-A- 3 358 550
- US-A- 4 202 091
- US-A- 4 751 612

## Beschreibung

Die Erfindung betrifft ein Chassis mit unlösbar mit dem Chassis verbundenen Befestigungselementen mit einer Befestigungseinrichtung zum Lagern und Befestigen von Bauelementen oder Chassiselementen.

Ein Gerätechassis gemäß dem Oberbegriff des Anspruches 1 ist aus US-A-4202091 bekannt.

Derartige Chassis sind in vielen Geräten insbesondere der Unterhaltungselektronik oder der Meßtechnik angeordnet. Auf derartigen Chassis, die entweder plattenförmig oder als Wanne oder in sonst einer Form, z. B. stufig ausgebildet sind, ist eine Vielzahl elektrischer und/oder mechanischer Bauelemente wie Motoren, Getriebe, Teilchassis, Schalter und anderes mehr angeordnet und befestigt. Diese Bauelemente sind zu ihrem Zusammenspiel über elektrische Leiter, Hebel, Gestänge und andere Antriebselemente miteinander verbunden, um die für das Gerät gewählten Funktionsabläufe durchzuführen.

Insbesondere im Bereich der Unterhaltungselektronik sind viele Gerätearten bekannt, die eine Vielzahl von Befestigungselementen für elektrische und mechanische Bau-und Übertragungselemente erfordern. Ein besonders auffälliges Beispiel ist das Chassis eines Videorecorders, das eine besonders hohe Anzahl von Befestigungselementen mit Befestigungseinrichtungen zum Lagern und Befestigen von vorwiegend mechanischen Bauelementen der Einfädeleinrichtungen, Bandantriebseinrichtungen, Kassetteneinzugs- und -auswurfseinrichtungen und dergleichen enthält. Derart komplizierte und schwer bestückbare Chassis sollen jedoch in der Unterhaltungselektronik kostengünstig hergestellt werden. Deshalb wird insbesondere dort nach rationellen Herstellungsmethoden gesucht, bei denen beispielsweise die nicht vom Chassis lösbaren Befestigungselemente möglichst in einem Arbeitsgang auf das Chassis aufgebracht werden. Sind beispielsweise geeignete Spritzwerkstoffe für ein derartiges Chassis vorhanden, kann das Chassis einschließlich der darauf angebrachten Befestigungselemente in einem Kunststoffspritzvorgang als Einkomponenten-Chassis hergestellt werden. Oft ist es jedoch aus Gründen der mechanischen Stabilität und der temperaturunabhängigen Maßhaltigkeit erforderlich, ein Zwei- oder Mehrkomponenten-Chassis herzustellen, dessen Chassiskörper oder wesentliche Teile davon aus Metall bestehen, auf dem die aus einem geeigneten Kunststoff hergestellten Befestigungselemente unlösbar angebracht sind. Beispielsweise bei der bekannten Outsert-Technik wird die Metallplatte des Chassis als eine der Begrenzungsflächen des Spritzkanales einer Kunststoffspritzanordnung verwendet. Die dadurch in einem Arbeitsgang hergestellten Befestigungselemente sind über auf der Metallplatte des Chassis auf liegende Spritzstege teilweise miteinander verbunden und durch durch Aussparungen in der Metallplatte hindurchgreifendes Spritzmaterial starr und unlösbar auf der Metallplatte befestigt. Die Befestigungselemente sind im allgemeinen so ausgebildet, daß die auf das Chassis aufzubringenden Bauelemente mittels Bestückungseinrichtungen in die Befestigungselemente eingesetzt bzw. eingerastet werden können und die Bauelemente durch einen Rastverschluß oder Schnappverschluß der Befestigungselemente in deren Befestigungseinrichtung gehaltert und gelagert werden.

Der einfachen Herstellung wegen werden auf das Chassis nicht Baueinheiten oder Baugruppen aufgesetzt. Vielmehr werden die Einzelteile einer Baueinheit oder einer Baugruppe unmittelbar auf dem Chassis gehaltert oder gelagert, so daß die Gesamtbestückung des Chassis kostengünstig in einem Arbeitsgang vollzogen werden kann. Bei einem derartigen Chassis besteht jedoch der Nachteil, daß bei einer Beschädigung eines Befestigungselementes in Folge unsachgemäßer Behandlung des Geräte oder auch in einem Servicefall das beschädigte Befestigungselement nicht ausgetauscht werden kann, sondern im ungünstigsten Fall das gesamte Chassis ausgetauscht werden muß. Dies stellt jedoch einen hohen Kostenaufwand für die Reparatur eines mit einem derartigen Chassis ausgerüsteten Gerätes dar, die häufig zu einem Ärger der Servicestelle und damit zum Nachteil des Herstellers führt.

Der Erfindung liegt deshalb die Aufgabe zugrunde, die Servicefreundlichkeit eines eingangs angegebenen Chassis wesentlich zu verbessern und zu verhindern, daß eine Beschädigung eines aufgrund günstiger Chassisherstellung unlösbar mit dem Chassis verbundenen Befestigungelementes zu einer Unbrauchbarkeit des gesamten Chassis führt.

Diese Aufgabe wird nach der Erfindung durch die im Kennzeichen des Anspruches 1 angegebene Merkmale in vorteilhafter Weise gelöst.

Der Vorteil der Erfindung liegt darin, daß dem Fachmann im Servicefall nicht nur Möglichkeiten zu einer Reparatur vermittelt werden, sondern daß zusätzlich die Mittel zur Reparatur und zur Durchführung der Reparatur zur Verfügung gestellt werden.

Besonders vorteilhaft ist es darüber hinaus, das Reparaturmittel, nämlich das einem unlösbarem Befestigungselement zugeordnete zusätzliche Reparaturelement an einer Sollbruchstelle trennbar in unmittelbarer Nähe des nicht lösbaren Befestigungselementes anzuordnen und an einer Sollbruchstelle trennbar, starr mit dem Chassis oder dem nicht lösbaren Befestigungselement zu verbinden oder an einem Halterungsteil zu befestigen. In beiden Fällen können die Reparaturelemente mit dem gleichen Spritzvorgang hergestellt werden, mit dem auch die Befestigungselemente an dem Gerätechassis hergestellt werden. Die Herstellung der Reparaturelemente erfordert somit keinen zusätzlichen Arbeitsgang.

Die Erfindung wird nachfolgend anhand einiger vorteilhafter Ausführungsbeispiele näher erläutert. In den zugehörigen Zeichnungen zeigen
- Fig. 1a-1c: drei unterschiedliche Ansichten eines Ausschnittes aus einem Gerätechassis mit einem mit dem Chassis unlösbar verbundenen Befestigungselement und einem daran angespritzten zugehörigen Reparaturelement,
- Fig. 2 - Fig. 4: je ein in Fig. 1a dargestellter Ausschnitt eines Gerätechassis mit einem Teil eines Bauelementes im Zustand des Bestückens (Fig. 2), der Halterung und Lagerung des Bauelementes (Fig. 3) und des Beschädigens eines Teils des Befestigungselementes bei der unsachgemäßen Entnahme des Bauelementes (Fig. 4),
- Fig. 5a - Fig. 5b: einen in Fig. 1a und Fig. 1b dargestellten Ausschnitt aus einem Gerätechassis mit beschädigtem Befestigungselement, darin eingesetztem Bauelement und ersatzweise eingesetztem Reparaturelement,
- Fig. 6a - Fig. 6d: in einer Seitenansicht einen Ausschnitt aus einem Gerätechassis mit einem säulenförmigen Befestigungselement zur Befestigung eines plattenförmigen Bauelementes im Rohzustand vor der Befestigung des Bauelementes (Fig. 6a), im befestigten Zustand des Bauelementes (Fig. 6b), im beschädigten Zustand (Fig. 6c) und im reparierten Zustand (Fig. 6d) der Befestigung des Bauelementes,
- Fig. 7a, Fig. 7b: eine Draufsicht und eine Seitenansicht eines Ausschnittes eines Einkomponenten-Gerätechassis mit einem einstückig an das Gerätechassis angespritzten Befestigungselement für eine Zugfeder und mit einem einstückig angespritztem Reparaturelement,
- Fig. 8: den in Fig. 7b dargestellten Gerätechassisausschnitt mit beschädigtem Befestigungselement und als Befestigungsersatz eingesetztem Reparaturelement,
- Fig. 9: ein Ausschnitt aus einem Reparaturelementebaum mit abbrechbaren Reparaturelementen,
- Fig. 10a - 10c: die Seitenansicht eines Ausschnittes aus einem Gerätechassis mit einem verallgemeinert dargestellten Befestigungselement und darin eingesetztem Bauelement im normalen Betriebsfall (Fig. 10a), im beschädigten Zustand des Befestigungselementes (Fig. 10b) und im reparierten Zustand (Fig. 10c).

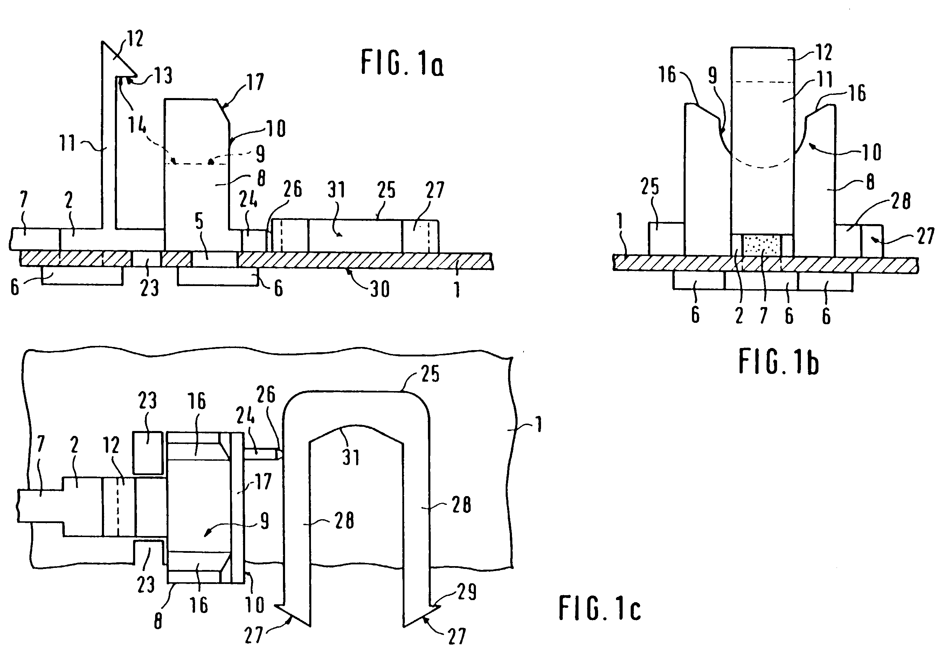

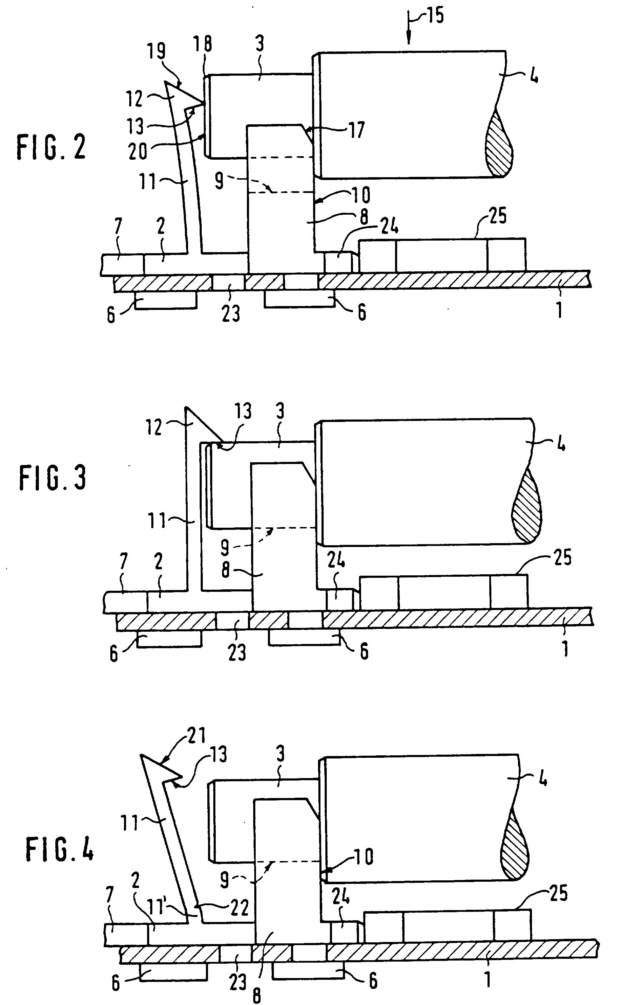

In den Figuren 1a und 1b sind zwei zueinander um 90° gedrehte Seitenansichten eines in Figur 1c als Draufsicht dargestellten Ausschnittes aus einem Gerätechassis 1 an der Stelle eines Befestigungselementes für den Lagerzapfen 3 eines in den Figuren 2 bis 4 dargestellten mechanischen oder elektrischen Bauelementes 4 schematisch dargestellt. Das Befestigungselement 2 ist in einer bestimmten Kunststoff-Spritztechnik, beispielsweise der sogenannten Outsert-Technik, auf die Chassisplatte des Gerätechassis 1 aufgebracht und über Durchbrüche 5 mittels angespritzter Befestigungsköpfe 6 unlösbar mit der Platte des Gerätechassis 1 verbunden. Die in einem Arbeitsgang auf das Gerätechassis 1 aufgebrachten Befestigungselemente sind über Spritzstege 7 miteinander verbunden. Das beispielsweise dargestellte Befestigungselement 2 enthält zur Lagerung und Befestigung des von ihm gehalterten Bauelementes 4 einen Lagerbock 8 mit einer Lagerhalbschale 9 zur Lagerung des Lagerzapfens 3 des Bauelementes 4 und außenseitig eine Anschlagfläche 10 für das Bauelement 4. Außerdem enthält das Bauelement 2 einen biegsamen Arm 11 mit einer Rastnase 12 an seinem Ende, deren Rastfläche 13 den in der Lagerhalbschale 9 des Lagerbockes 8 gelagerten Lagerzapfen 3 vor einem Herausfallen aus der Lagerhalbschale sichert, wie aus Figur 3 zu erkennen ist. Die Lagerhalbschale 9, die Anschlagfläche 10 und die Rastfläche 13 bilden die Halterungseinrichtung 14 des Befestigungselementes 2 zur Lagerung und Befestigung des Bauelementes 4 an dessen Lagerzapfen 3.

In den Figuren 2 bis 5b ist das in den Figuren 1a bis 1c dargestellte Befestigungselement für ein Bauelement 4 im Zusammenwirken mit diesem Bauelement 4 näher dargestellt. Die Darstellung des im übrigen nicht näher beschriebenen und gezeigten Bauelementes 4 in den genannten Figuren umfaßt lediglich den Teil mit dem Lagerzapfen 3. In der Darstellung der Figur 2 wird das Chassis 1 gerade in Pfeilrichtung 15 mit dem Bauelement 4 bestückt. Die Gleitflächen 16 und 17 führen das Bauelement 4 bei der Bestückung in die richtige Position innerhalb des Befestigungselementes 2. Dabei gleitet die Stirnkante 18 des Lagerzapfens 3 des Bauelementes 4 entlang der Gleitfläche 19 des biegsamen Armes 11 des Befestigungselementes und anschließend die Stirnfläche 20 des Lagerzapfens 3 auf der Rastnase 12 des biegsamen Armes bis der Lagerzapfen 3 des Bauelementes 4 den Grund der Lagerhalbschale 9 erreicht und der dann freiwerdende ausgebogene Rastarm 11 zurückfedert und mit seiner Rastfläche 13 den Lagerzapfen 3 übergreift (Fig. 3), so daß der Lagerzapfen 3 radial allseitig von dem Befestigungselement gehaltert ist. Will man, beispielsweise im Servicefall, das Bauelement 4 aus seiner Lagerung im Befestigungselement 2 herausnehmen, muß der Rastarm 11 durch einen Druck in Richtung des Pfeils 21 soweit zur Seite gebogen werden, daß das Bauelement 4 aus der Lagerhalbschale des Lagerbockes 8 des Befestigungselementes 2 herausgehoben werden kann, wie Figur 4 zeigt.

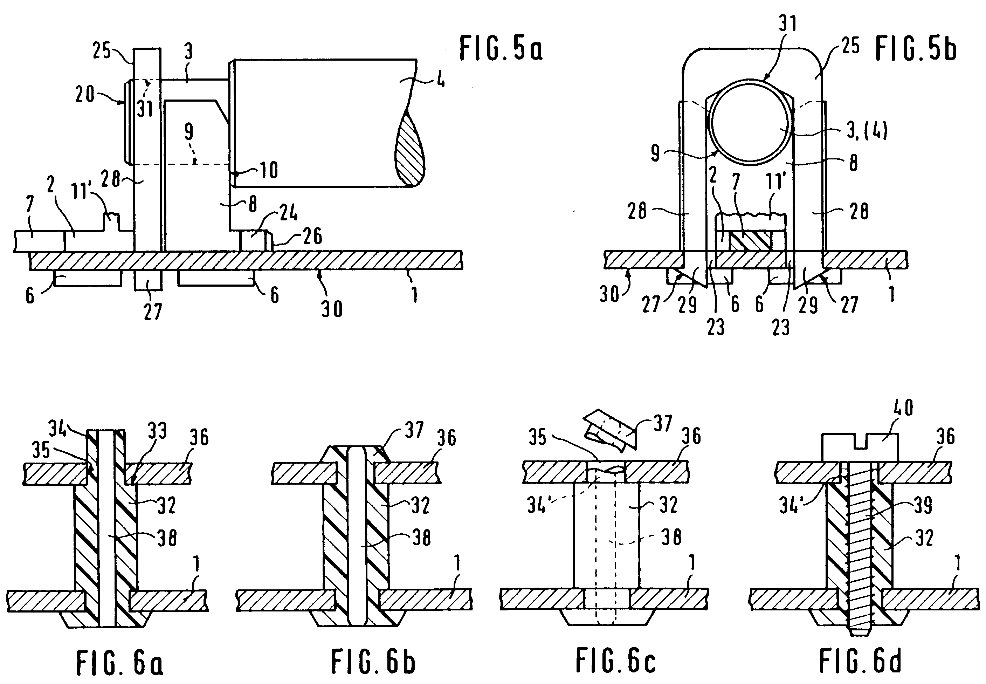

Wird der Rastarm 11 des Befestigungselementes 2 durch einen Druck 21 auf seine Gleitfläche 19 zu weit ausgebogen, besteht die Gefahr, daß er an einer Bruchstelle 22 abbricht, wie in Figur 4 ebenfalls dargestellt ist. Damit verliert das so beschädigte Befestigungselement 2 eine wesentliche Halterungsfunktion und wird unbrauchbar. Im dargestellten Ausführungsbeispiel sei angenommen, daß es nicht möglich ist, wegen der Vielzahl der auf dem Gerätechassis angeordneten Bauelemente und der Dichte der Bestückung das beschädigte und unbrauchbar gewordene Befestigungselement von dem Gerätechassis 1 zu entfernen und durch ein neues, unbeschädigtes gleichartiges Befestigungselement zu ersetzen. In diesem Fall müßte das gesamte Gerätechassis aus dem es enthaltenden Gerät ausgewechselt werden, was außer den hohen Kosten zusätzlich ein hohes Unbehagen auf Seiten des Besitzers des Gerätes und dem Service verursacht. Deshalb enthält das in den Figuren 1a bis 5b dargestellte Ausführungsbeispiel eines Gerätechassis unmittelbar an den Lagerbock 8 des dort dargestellten Befestigungselementes 2 angrenzend in der Chassisplatte des Chassis 1 zwei Durchbrüche 23 als Befestigungsvorrichtung für ein über einen Steg 24 an das Befestigungselement angespritztes U-förmiges Reparaturelement 25. Dieses Reparaturelement wird an einer Sollbruchstelle 26 von dem Steg 24 zum Befestigungselement 2 abgebrochen und an seinen Gleitflächen 27 am Ende seiner beiden Schenkel 28 über den Lagerzapfen 3 des Bauelementes 4 in die Durchbrüche 23 geschoben, bis die Rasthaken 29 am Ende der Schenkel 28 des Reparaturelementes 25 hinter die Unterseite 30 der Platte des Gerätechassis 1 rasten, wie in den Figuren 5a und 5b dargestellt ist. Die Innenseite 31 des Verbindungsstückes der beiden Schenkel 28 des U-förmigen Reparaturelementes 25 ersetzt die Rastfläche 13 des durch die Beschädigung ausgefallenen Rastarmes 11 des Befestigungselementes 2 und bildet anstelle dieser Rastfläche 13 ein Teil der Halterungseinrichtung 14 des Befestigungselementes 2, dessen andere Einrichtungsteile die unbeschädigte Lagerhalbschale 9 und die unbeschädigte Anschlagfläche 10 des Lagerbockes 8 des Befestigungselementes 2 sind.

In den Figuren 6a bis 6d ist ein Ausschnitt des Gerätechassis 1 mit einem säulenförmigen Befestigungselement 32 dargestellt, das aus einem temperaturverformbaren Material besteht und unlösbar mit der Chassisplatte verbunden ist. An seinem Kopfende enthält das Befestigungselement 32 eine ringförmige Auflagefläche 33 um einen zentralen Hohldorn 34, der durch eine Bohrung 35 eines auf der ringförmigen Auflagefläche des säulenförmigen Befestigungselementes 32 lagernden Subchassis 36 greift, wie Figur 6a zeigt. Der Hohldorn wird nach dem Aufsetzen des Subchassis 36 auf das säulenförmige Befestigungselement 32 thermisch zu einem Haltekopf 37 verformt, der die Bohrung 35 des Subchassis 36 übergreift und auf dem säulenförmigen Befestigungselement 32 festhält, wie Figur 6b zeigt. Muß im Servicefall dieser Haltekopf 37 entfernt werden oder platzt dieser aus irgend einem Grunde ab, wie in Figur 6c schematisch dargestellt ist, kann das säulenförmige Befestigungselement 32 dennoch weiterhin als Befestigungselement verwendet werden, da es eine durchgängige zentrale Bohrung 38 als Befestigungseinrichtung für eine Schneidschraube 39 enthält. Der Kopf 40 der als Reparaturelement in die zentrale Bohrung 38 des säulenförmigen Befestigungselementes 32 eingedrehten Schneidschraube hält das Subchassis 36 in der gleichen Weise fest, wie der ursprüngliche Haltekopf 37 des säulenförmigen Befestigungselementes 32, wie Figur 6d zeigt.

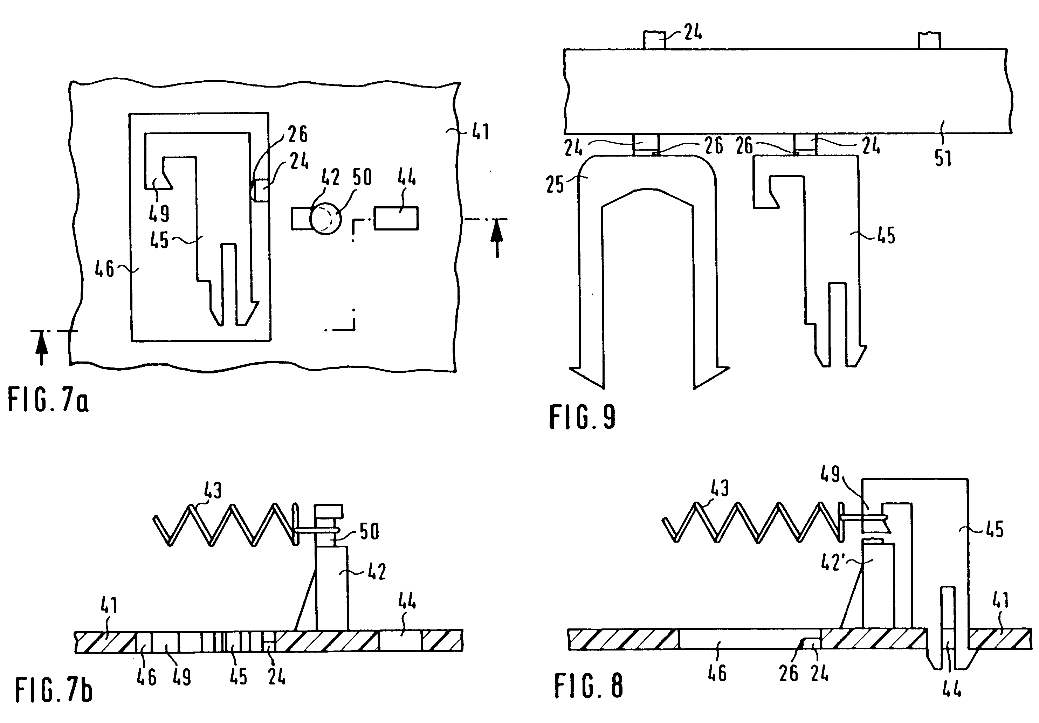

Die Figuren 7a und 7b zeigen in einer Draufsicht und einer Seitenansicht einen Ausschnitt aus einem gespritzten Kunststoff-Gerätechassis 41. In diesem Ausschnitt ist an das Gerätechassis 41 ein säulenförmiges Befestigungselement 42 zur Befestigung und Halterung einer Zugfeder 43 angespritzt. Unmittelbar hinter dem säulenförmigen Befestigungselement enthält das Gerätechassis 41 einen Befestigungsdurchbruch 44 zur Befestigung eines hakenförmigen Reparaturelementes 45, das in einem Ausschnitt 46 über einen Steg 47 einstückig mit dem Gerätechassis 41 verbunden ist. Wird das säulenförmige Befestigungselement 42 durch einen unsachgemäßen Umgang mit dem Gerätechassis 41 teilweise oder vollständig abgebrochen, wie in Figur 8 schematisch dargestellt ist, wird das hakenförmige Reparaturelement 45 an einer Sollbruchstelle 48 aus dem Ausschnitt 46 des Gerätechassis 41 herausgebrochen und in den Befestigungsdurchbruch 44 eingerastet. Der Befestigungshaken 49 des Reparaturelementes für die Zugfeder 43 liegt in diesem Zustand des Reparaturelementes 45 an der gleichen Stelle wie zuvor der Befestigungskopf 50 des unbeschädigten säulenförmigen Befestigungselementes 42, wie Figur 8 zeigt.

In den zuvor genannten Ausführungsbeispielen von mit dem Gerätechassis unlösbar verbundenen Befestigungselementen 2, 32 oder 42, deren Halterungseinrichtung 14 zur Halterung und Befestigung bestimmter Bauelemente bei einer Beschädigung der Befestigungselemente mit den zugeordneten Reparaturelementen 25, 39 oder 45 ersatzweise wieder hergestellt werden kann, sind unterschiedliche Möglichkeiten für die Bereithaltung der Reparaturelemente beispielhaft dargestellt. Eine weitere Möglichkeit zur Bereithaltung derartiger Reparaturelemente zeigt das in Figur 9 dargestellte Ausführungsbeispiel. An einer Bevorratungsleiste 51 sind über Stege 24 unterschiedliche Reparaturelemente 25, 45 angespritzt, die bei Bedarf an Sollbruchstellen 26 von den Stegen 24 der Bevorratungsleiste 51 abgebrochen und in die entsprechenden Befestigungseinrichtungen für die Reparaturelemente am Geratechassis und/oder an dem entsprechenden Befestigungselement eingesetzt werden. Diese Bevorratungsleiste mit den daran angespritzten Reparaturelementen kann im gleichen Arbeitsgang hergestellt werden, mit dem die Befestigungselemente 2 auf das Gerätechassis 1 aufgebracht oder in dem ein Einkomponenten-Gerätechassis hergestellt wird.

In Figur 10a ist nochmals ein Ausschnitt aus einem Gerätechassis mit einem schematisch dargestellten Befestigungselement 52 in einer Seitenansicht gezeigt. Das Befestigungselement 52 ist über einen das Gerätechassis 1 durchsetzenden angespritzten Ansatz 53 und einen gespritzten Kunststoffsteg 54 unlösbar mit dem Gerätechassis 1 verbunden und so ausgestaltet, daß das von ihm in einer Halterungseinrichtung zu halternde und zu befestigende Bauelement 55 in einem automatischen Bestrnckungsvorgang in die Halterungseinrichtung 14 des Bauelementes eingesetzt werden kann. Die Halterungseinrichtung des Befestigungselementes 55 ist in Fig. 10a durch die dick gestrichelte Linie 14.1, 14.2 schematisch dargestellt.

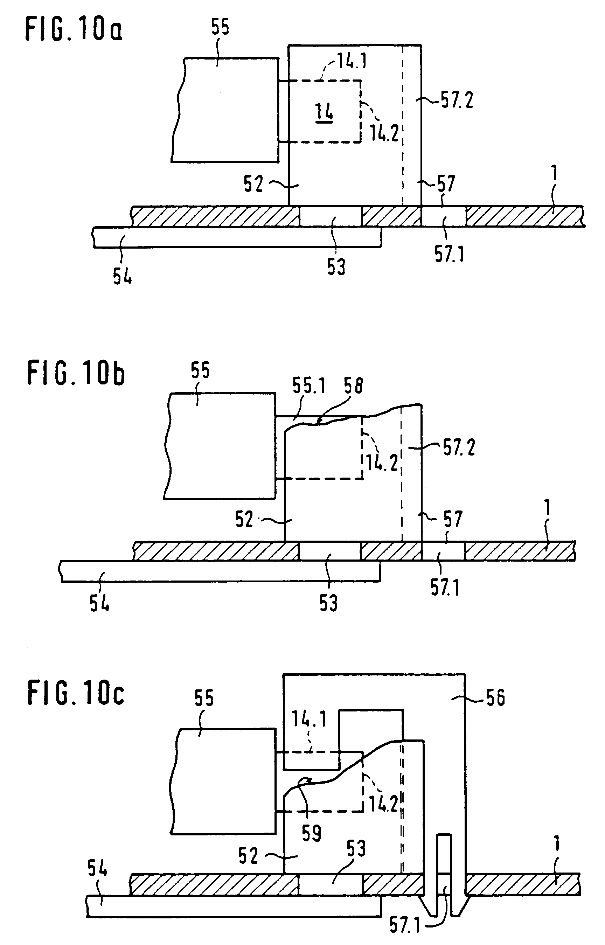

Figur 10b ist die gleiche Darstellung wie die Figur 10a jedoch mit einem durch einen hier nicht näher beschriebenen Einfluß beschädigten Befestigungselement 52'. In Folge der Beschädigung des Befestigungselementes 52 ist die Halterungseinrichtung 14 nicht mehr vollständig, so daß das Bauelement 55 von dem beschädigten Befestigungselement 52 nicht mehr bestimmungsgemäß gehaltert und gelagert werden kann. Deshalb ist ein Reparaturelement 56 vorgesehen, das die durch die mögliche Beschädigung des Befestigungselementes 52 entfallenden Teile 14.1 ersetzt. Zur Befestigung eines dem beschädigten Befestigungselement zugeordneten Reparaturelementes 56 ist im schematisch dargestellten Ausführungsbeispiel unmittelbar hinter dem Befestigungselement im Chassis 1 ein zusätzlicher Durchbruch 57.1 und im Anschluß an diesen Durchbruch im Befestigungselement 52 eine Befestigungsnut 57.2 als Befestigungsvorrichtung 57 für das zugehörige Befestigungselement 52 angebracht. In dem in die Befestigungsvorrichtung 57 eingesetzten Zustand des Reparaturelementes 56 liegt der den Teil 14.1 der Halterungseinrichtung 14 des Befestigungselementes 52 ersetztende Halterungseinrichtungsteil 14.1' des Reparaturelementes 56 an der Stelle, an der beim unbeschädigten Befestigungselement 52 der Halterungseinrichtungteil 14.1 angeordnet war, wie Figur 10c deutlich zeigt. Vor dem Einsetzen des Reparaturelementes 56 mußte die Bruchkante 58 (Fig. 10b) des beschädigten Befestigungselementes derart abgetragen werden (Abtragkante 59, Fig. 10c), daß genügend Raum geschaffen ist, das Reparaturelement in seine Befestigungseinrichtung einzusetzen.

## Patentansprüche

1. Gerätechassis (1) mit unlösbar mit dem Chassis verbundenen Befestigungselementen (52) mit wenigstens einer Halterungseinrichtung (14) zum Lagern, Haltern und Befestigen auf dem Chassis angeordneter Bauelemente (55) oder Subchassis (36), denen jeweils das die Halterungseinrichtung enthaltende Befestigungselement zugeordnet ist,
**dadurch gekennzeichnet,**
- daß Reparaturelemente (56) vorgesehen sind,
- daß an oder im Chassis (1), unmittelbar bei bestimmten Befestigungselementen (52) jeweils eine Befestigungsvorrichtung (57) zur unverrückbaren Halterung und Befestigung eines dem bestimmten Befestigungselement zugeordneten Reparaturelementes (56) ausgebildet ist
- so daß nach einer Beschädigung (58) eines der bestimmten Befestigungselemente (52), das dem beschädigten Befestigungselement zugeordnete Reparaturelement (56) in die entsprechende, dem beschädigten Befestigungselement zugeordnete Befestigungsvorrichtung (57) einsetzbar ist, wobei jedes Reparaturelement (56) eine zweite Halterungseinrichtung (14.1') enthält, die in dem Zustand, in dem das dem beschädigten Befestigungselement (52') zugeordnete Reparaturelement in die dem beschädigten Befestigungselement zugeordnete Befestigungsvorrichtung eingesetzt ist, allein oder gemeinsam mit bestimmten nicht beschädigbaren Teilen (14.2, 14.3) der Halterungseinrichtung (14) des beschädigten Befestigungselementes am Ort der Halterungseinrichtung dieses Befestigungselementes ersatzweise eine der Halterungseinrichtung (14) des nicht beschädigten Befestigungselementes (52) gleichartige Halterungseinrichtung (14') ist.

2. Gerätechassis nach Anspruch 1,
**dadurch gekennzeichnet,**
daß wenigstens ein Teil der zusätzlichen Reparaturelemente (25; 45) an Sollbruchstellen (26) trennbar mit dem Chassis oder mit nicht lösbaren Befestigungselementen (2) starr verbunden ist.

3. Gerätechassis nach Anspruch 1,
**dadurch gekennzeichnet,**
daß wenigstens ein Teil der zusätzlichen Reparaturelemente (25; 45) an Sollbruchstellen (26) trennbar an einer Bevorratungsleiste (51) befestigt ist.

## Claims

1. Chassis (1) having fastening elements (52), which are permanently connected to the chassis and have at least one mounting device (14) for supporting, retaining and fastening components (55) or sub-chassis (36), which are disposed on the chassis and with which in each case the fastening element containing the mounting device is associated,
characterized in that
- repair elements (56) are provided,
- formed on or in the chassis (1) immediately adjacent to specific fastening elements (52) is in each case one fastening device (57) for immovably retaining and fastening a repair element (56) associated with the specific fastening element
- so that, after damage (58) to one of the specific fastening elements (52), the repair element (56) associated with the damaged fastening element is insertable into the appropriate fastening device (57) associated with the damaged fastening element, each repair element (56) comprising a second mounting device (14.1') which, in the state in which the repair element associated with the damaged fastening element (52') has been inserted into the fastening device associated with the damaged fastening element, on its own or jointly with specific non-damagable parts (14.2, 14.3) of the mounting device (14) of the damaged fastening element at the location of the mounting device of said fastening element is a replacement mounting device (14') identical in type to the mounting device (14) of the non-damaged fastening element (52) .

2. Chassis according to claim 1,
characterized in that
at least some of the additional repair elements (25; 45) are rigidly connected to the chassis or to non-detachable fastening elements (2) so as to be separable at rupture joints (26) .

3. Chassis according to claim 1,
characterized in that
at least some of the additional repair elements (25; 45) are fastened to a supply strip (51) so as to be separable at rupture joints (26).

## Revendications

1. Châssis d'appareil (1) comprenant des éléments de fixation (52) reliés au châssis de façon inamovible avec au moins un système de support (14) pour le montage, le support et la fixation d'éléments de construction (55) ou de sous-châssis (36) disposés sur le châssis, auxquels est attribué respectivement l'élément de fixation contenant le système de support, caractérisé en ce que
- des éléments de réparation (56) sont prévus,
- sur ou dans le châssis (1), directement près de certains éléments de fixation (52), un dispositif de fixation (57) est réalisé respectivement pour le support immobile et la fixation d'un élément de réparation (56) attribué à l'élément de fixation déterminé
- de sorte que, après une détérioration (58) de l'un des éléments de fixation (52) déterminés, l'élément de réparation (56) attribué à l'élément de fixation endommagé peut être inséré dans le dispositif de fixation (57) approprié, attribué à l'élément de fixation endommagé, chaque élément de réparation (56) contenant un deuxième système de support (14.1') qui, dans l'état où l'élément de réparation attribué à l'élément de fixation (52') endommagé, est inséré dans le dispositif de fixation attribué à l'élément de fixation endommagé, seul ou conjointement avec certaines parties (14.2, 14.3) non endommageables du système de support (14) de l'élément de fixation endommagé à l'endroit du système de support de cet élément de fixation, est en guise de remplacement un système de support (14') similaire au système de support (14) de l'élément de fixation (52) non endommagé.

2. Châssis d'appareil selon la revendication 1, caractérisé en ce qu'au moins une partie des éléments de réparation supplémentaires (25; 45) est reliée, en des points destinés à la rupture, de façon amovible au châssis ou de façon rigide à des éléments de fixation (2) non amovibles.

3. Châssis d'appareil selon la revendication 1, caractérisé en ce qu'au moins une partie des éléments de réparation (25; 45) supplémentaires est fixée de façon amovible à une barrette d'approvisionnement (51) en des points destinés à la rupture (26).
